# EUROPÄISCHE PATENTSCHRIFT

(11) **EP 0 995 220 B1**
(45) Veröffentlichungstag und Bekanntmachung des Hinweises auf die Patenterteilung: **19.01.2005**
(21) Anmeldenummer: 98947307.9
(22) Anmeldetag: 20.07.1998
(51) Int. Cl.: H01J 37/34

(54) **TARGETKATHODENANORDNUNG**
TARGET CATHODE ASSEMBLY
ENSEMBLE CATHODE CIBLE

(30) Priorität: 18.07.1997 DE 19731025
(43) Veröffentlichungstag der Anmeldung: 26.04.2000
(73) Patentinhaber: VON ARDENNE ANLAGENTECHNIK GmbH, 01324 Dresden (DE)
(72) Erfinder: ERBKAMM, Wolfgang, 01257 Dresden (DE); STRÜMPFEL, Johannes, D-01277 Dresden (DE); HECHT, Hans-Christian, D-01689 Weinböhla (DE); DIMER, Martin, D-01277 Dresden (DE); GEHM, Klaus, D-01277 Dresden (DE); SCHULZE, Dietmar, D-01474 Schönfeld (DE)
(74) Vertreter: Lippert, Stachow, & Partner
(86) Internationale Anmeldenummer: PCT/DE1998/002024
(87) Internationale Veröffentlichungsnummer: WO 1999/004412

(56) Entgegenhaltungen:
- DE-A- 4 301 516
- DE-A- 4 304 581
- GB-A- 2 255 105
- PATENT ABSTRACTS OF JAPAN vol. 096, no. 007, 31. Juli 1996 & JP 08 074047 A (SONY CORP), 19. März 1996

## Beschreibung

Die Erfindung betrifft eine Targetkathodenanordnung mit einem Target, das im laufenden Betrieb einen Erosionsgraben ausbildet, wobei unter dem Target Trageelemente, ein Kühlsystem und ein Magnetsystem angeordnet ist, welches eine auf der dem Target gegenüberliegenden Seite der Targetkathodenanordnung angeordnete Rückschlußplatte beinhaltet.

Eine Targetkathodenanordnung der eingangs genannten Art ist beispielsweise aus der deutschen Offenlegungsschrift 43 01 516 A1 bekannt. Diese Targetkäthodenanordnung besteht aus einem Target auf einem Targetgrundkörper, welches mittels Pratzleisten, die das Target am äußeren Rand umgreifen, an einen Grundkörper befestigt ist. Dabei sind die Pratzleisten über Schraubverbindungen mit dem Grundkörper verbunden.

Unter dem Target befindet sich ein Kühlsystem und ein Magnetsystem, dessen Magnetfeld das Targetmaterial durchdringt.

Durch das Magnetfeld und das Anlegen eines elektrischen Feldes erodiert im Hochvakuum das Targetmaterial, welches auf Substraten als Schicht abgeschieden wird. Bei dieser Schichtabscheidung verbraucht sich das Targetmaterial, wobei ein durch das Magnetfeld beeinflußter Erosionsgraben in dem Target entsteht.

Insbesondere bei reaktiven Prozessen hat es sich gezeigt, daß neben der gewollten Plasmaentladung über dem Target auch unzulässige Plasmaentladungen in Form von Bogenentladungen an der übrigen Oberfläche der Targetkathodenanordnung auftreten können. Diese Bogenentladungen führen zu negativen Beeinträchtigungen der zu erzeugenden Schicht, vor allem durch eine kurzzeitige Unterbrechung des Beschichtungsvorganges.

Insbesondere sind diese unzulässigen Bogenentladungen bei sogenannten Doppelmagnetron festzustellen, bei denen zwei unmittelbar benachbarte Targetkathodenanordnungen eingesetzt werden, die zweckmäßigerweise gegenseitig mit wechselnder Polarität betrieben werden. Hierbei kommt es zu Bogenentladungen zwischen den Targetkathodenanordnungen mit den bereits dargestellten negativen Erscheinungen.

Der Erfindung liegt damit die Aufgabe zugrunde, Bogenentladungen außerhalb der Targetoberfläche an Targetkathodenanordnungen zu verhindern.

Gemäß der Erfindung wird diese Aufgabe dadurch gelöst, daß die Targetkathodenanordnung mit einer Umhüllung aus einem weichmagnetischen Material versehen ist. Diese Umhüllung bedeckt die Außenfläche der Targetkathodenanordnung unter Freilassung der aktiven Targetoberfläche zumindest teilweise. Diese Überdeckung wird dabei derart gestaltet, daß an Punkten auf der Außenfläche der Targetkathodenanordnung, auf denen eine Normalkomponente eines elektrischen Feldes auftritt, eine Tangentialkomponente eines magnetischen Streufeldes zumindest unterdrückt wird. Die Umhüllung ist mit der Targetkathodenanordnung elektrisch leitend verbunden.

Sowohl das elektrische als auch das magnetische Feld können in Bezug auf die Oberfläche der Targetkathodenanordnung in verschiedenen Richtungen auftreten. Dabei weist das magnetische Feld von Punkt zu Punkt unterschiedliche Normal- und Tangentialkomponenten auf. Die Tangentialkomponenten liegen bei Punkten auf ebenen Teilen der Außenfläche der Targetkathodenanordnung parallel zur Außenfläche und bei gekrümmten Außenflächenteilen tangential zur Krümmung, während die Normalkomponenten stets senkrecht zu den Tangentialkomponenten verlaufen.

Das durch die Magneten erzeugte Magnetfeld tritt in praxi nicht nur durch den Targetkörper hindurch, sondern erscheint außerhalb der übrigen Targetkathodenanordnung auch als magnetisches Streufeld. Die Erfindung verhindert oder verringert nunmehr ein gleichzeitiges Auftreten einer Tangentialkomponente des magnetischen Streufeldes zusammen mit einer Normalkomponente des elektrischen Feldes. Dabei hat es sich gezeigt, daß durch die Dämpfung der Tangentialkomponente des magnetischen Feldes die unerwünschten Bogenentladungen unterdrückt oder verhindert werden können.

In einer Ausgestaltung der Erfindung ist vorgesehen, daß die Umhüllung die Außenseite der Targetkathodenanordnung im Bereich zwischen der Rückschlußplatte und dem äußeren Rand des Erosionsgrabens vollständig umschließen. Durch eine derart vollständige Umhüllung wird das Auftreten von unerwünschten Bogenentladungen vollständig vermieden.

Zweckmäßig ist es, die Umhüllung aus einem Blech mit einer Stärke von 0,3 bis 3 mm bestehen zu lassen. Durch ein derartiges Blech wird die Tangentialkomponente des magnetischen Streufeldes an jedem Punkt der Oberfläche der Targetkathodenanordnung verringert, ohne dabei jedoch das gewollte magnetische Feld durch den Targetkörper hindurch wesentlich negativ zu beeinflussen.

In einer weiteren Ausgestaltung der Erfindung ist vorgesehen, daß die Umhüllung ausschließlich durch magnetischen Kraftschluß befestigt ist. Bei dieser Ausgestaltung wird das Vorhandensein eines Reststreufeldes an der Targetkathodenanordnung zur Halterung ausgenutzt, wodurch zusätzliche Befestigungselemente entfallen und die Umhüllung leicht montierbar und auswechselbar ist.

Weiterhin ist es zweckmäßig, die Umhüllung mehrteilig auszuführen. Die mehrteilige Ausführung bietet einerseits den Vorteil, daß sie gegebenenfalls leichter herstellbar ist und andererseits Teile auswechselbar sind.

Eine Targetkathodenanordnung, bei der das Target mittels einer Pratzleiste gehalten wird, ist derart ausgeführt, daß die Umhüllung im wesentlichen nur die Außenfläche der Pratzleiste abdeckt. Dies kann auch dadurch fortgebildet werden, daß die Pratzleiste aus unterschiedlichen Materialien besteht, wobei die Außenseite der Pratzleiste aus weichmagnetischem Material gefertigt ist. Damit wird eine teilweise Abdeckung der Außenfläche der Targetkathodenanordnung erzielt und zwar genau in den Bereichen, in denen die Bogenentladungen erfahrungsgemäß am häufigsten auftreten. Außerdem kann mit der Umhüllung der Effekt erzielt werden, daß sich Sputtermaterial nicht mehr direkt auf der Pratzleiste sondern auf der Umhüllung ablagert, die leicht auswechselbar ist, so daß die Pratzleiste durch diese Ausgestaltung geschont wird.

Die Schonung der Außenfläche der Targetkathodenanordnung wird dadurch besonders unterstützt, daß in einer Fortbildung der Ausgestaltung der Erfindung die Außenfläche der Umhüllung derart oberflächenbehandelt ist, daß sie im Vergleich zu unbehandelten Oberflächen bessere Hafteigenschaften für das Schichtmaterial aufweist. Damit wird sich Schichtmaterial nicht mehr direkt auf die Oberfläche der Targetkathodenanordnung sondern vielmehr auf der Umhüllung ablagern, die sodann als Wegwerfartikel ausgeführt werden kann und damit erhebliche Reinigungsarbeiten entfallen.

Die Erfindung soll nachfolgend anhand eines Ausführungsbeispieles näher erläutert werden. Die zugehörige Zeichnung zeigt einen Schnitt durch eine erfindungsgemäße Targetkathodenanordnung. Dieses besteht aus einem Target 1, welches mittels Pratzleisten 2 auf Tragelementen 3 aufgespannt ist. Dabei ist das Target 1 auf einer Targetträgerplatte 4 befestigt. Diese Targetträgerplatte 4 sorgt für eine Kühlung des Targets, da sie in Wärmekontakt mit einem nicht näher dargestellten Kühlsystem steht. Unter dem Target 1 sind Magnete 5 angeordnet, deren Magnetfelder das Target 1 durchdringen. Beim Sputtern des Targets 1 entsteht ein Erosionsgraben 6.

Unter den Magneten 5 ist eine Rückschlußplatte 7 angeordnet, auf die sich die Tragelemente 3 abstützen.

An der Außenseite des Targets ist eine Umhüllung 8 vorgesehen. Diese Umhüllung 8 umgreift die Rückschlußplatte 7 an ihrer Unterseite und erstreckt sich sodann an der Außenseite der Targetkathodenanordnung bis zur Pratzleiste 2 und umschließt diese ebenfalls bis zum Rand des Erosionsgrabens 6.

Gerade im Bereich zwischen der Pratzleiste 2 und dem Magneten 3 ist eine Zone verstärkter Bogenentladung, die durch die Umhüllung 8 wirkungsvoll verhindert wird, da diese das Magnetstreufeld an sich und damit insbesondere auch die Tangentialkomponenten des Magnetfeldes abschwächt und somit das Zusammentreffen von Normalkomponenten des elektrischen Feldes und Tangentialkomponenten des magnetischen Feldes erschwert.

Insbesondere zur benachbarten Anordnung zweier derartiger Targetkathodenanordnungen ist es zweckmäßig, ein ebenfalls weichmagnetisches Abschirmblech 9 vorzusehen. Dabei kann die Umhüllung 8 mit diesem Abschirmblech 9 integriert werden. Auf jedem Fall ist es zweckmäßig, das Abschirmblech 9 und die Umhüllung 8 magnetisch miteinander zu verbinden.

Die Umhüllung liegt an der Außenfläche des Target dicht an und wird durch dieses dichte Anliegen auf gleiches Potential wie die Außenfläche der Targetkathodenanordnung selbst gelegt. Damit wird es möglich, daß auch bei nebeneinander angeordneten Targetkathodenanordnungen, deren Polarität ständig wechselt, auch die Umhüllung ihrer Polarität zusammen mit der umhüllten Targetkathodenanordnung wechselt.

### Bezugszeichenliste

- 1: Target
- 2: Pratzleiste
- 3: Tragelement
- 4: Targetträgerplatte
- 5: Magnet
- 6: Erosionsgraben
- 7: Rückschlußplatte
- 8: Umhüllung
- 9: Abschirmblech

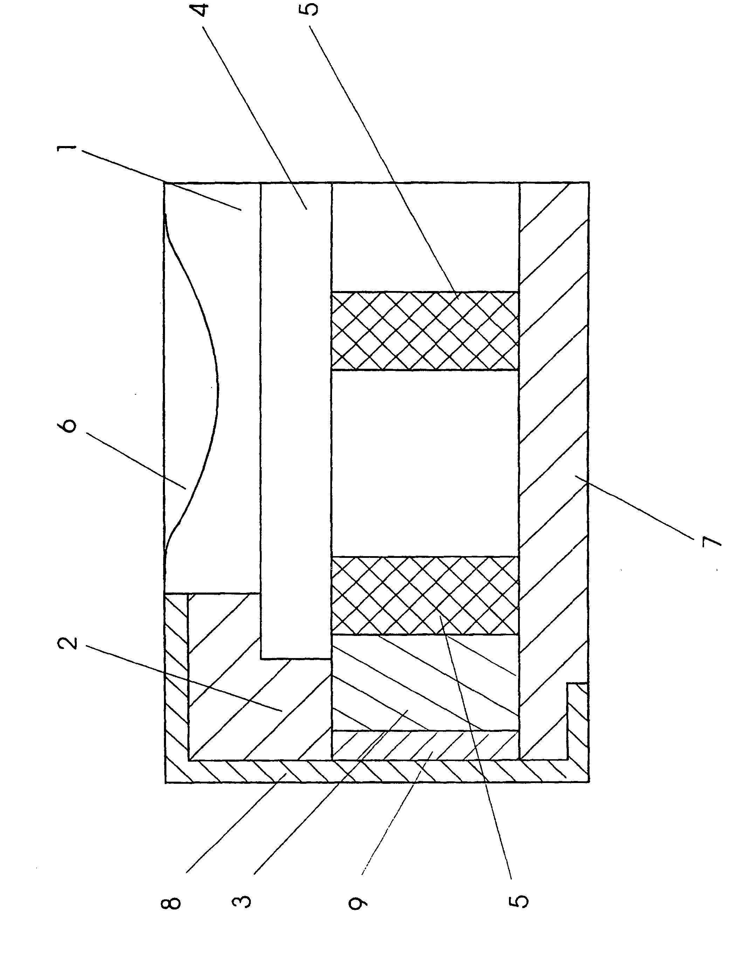

## Patentansprüche

1. Targetkathodenanordnung mit einem Target (1), das im laufenden Betrieb einen Erosionsgraben (6) ausbildet, wobei unter dem Target Tragelemente (3), ein Kühlsystem und ein Magnetsystem angeordnet ist, welches eine auf der dem Target gegenüberliegenden Seite der Targetkathodenanordnung angeordnete Rückschlußplatte beinhaltet, **dadurch gekennzeichnet, daß** die Targetkathodenanordnung mit einer Umhüllung (8) aus einem weichmagnetischen Material versehen ist, die die Außenseite der Targetkathodenanordnung unter Freilassung der aktiven Targetoberfläche zumindest teilweise derart bedeckt, daß an Punkten auf der Außenfläche, auf denen eine Normalkomponente eines elektrischen Feldes auftritt, eine Tangentialkomponente eines magnetischen Streufeldes zumindest unterdrückt wird und
daß die Umhüllung (8) mit der Targetkathodenanordnung elektrisch verbunden ist.

2. Targetkathodenanordnung nach Anspruch 1, **dadurch gekennzeichnet, daß** die Umhüllung (8) die Außenseite im Bereich zwischen der Rückschlußplatte (7) und dem äußeren Rand des Erosionsgrabens (6) vollständig umschließt.

3. Targetkathodenanordnung nach Anspruch 1 oder 2, **dadurch gekennzeichnet, daß** die Umhüllung (8) aus einem Blech mit einer Stärke von 0,3 bis 3 mm besteht.

4. Targetkathodenanordnung nach einem der Ansprüche 1 bis 3, **dadurch gekennzeichnet, daß** die Umhüllung (8) ausschließlich durch einen magnetischen Kraftschluß befestigt ist.

5. Targetkathodenanordnung nach einem der Ansprüche 1 bis 4, **dadurch gekennzeichnet, daß** die Umhüllung (8) mehrteilig ausgeführt.

6. Targetkathodenanordnung nach Anspruch 1 oder einem der Ansprüche 3 bis 5, **dadurch gekennzeichnet, daß** bei einem mittels einer Pratzleiste (2) gehaltenen Target (1) die Umhüllung (8) im wesentlich nur die Außenfläche der Pratzleiste (2) abdeckt.

7. Targetkathodenanordnung nach einem der Ansprüche 1 bis 6, **dadurch gekennzeichnet, daß** bei einem mittels einer Pratzleiste (2) gehaltenem Target (1) die Pratzleiste (2) aus unterschiedlichem Materialien besteht, wobei die Außenseite der Pratzleiste (2) aus weichmagnetischem Material besteht.

## Claims

1. Target cathode apparatus having a target (1) forming an erosion pit (6) in current operation, with support elements (3), a cooling system and a magnet system arranged under the target, and comprising a ground plate arranged on the side of the target cathode apparatus opposed to the target, **characterized in that** the target cathode apparatus is provided with an envelope (8) of a soft magnetic material covering the outside of the target cathode apparatus, while leaving the active target surface at least partially exposed, in such manner that at points on the outer face where a normal component of an electric field occurs, a tangential component of a stray magnetic field is at least depressed, and **in that** the envelope (8) is electrically connected to the target cathode apparatus.

2. Target cathode apparatus according to claim 1, **characterized in that** the envelope (8) completely encloses the outside in the region between the ground plate (7) and the outer edge of the erosion pit (6).

3. Target cathode apparatus according to claim 1 or 2, **characterized in that** the envelope consists of a metal sheet 0.3 to 3 mm in thickness.

4. Target cathode apparatus according to any of claims 1 to 3, **characterized in that** the envelope (8) is fixed exclusively by magnetic attraction.

5. Target cathode apparatus according to claim 1 to 4, **characterized in that** the envelope (8) is multipartite.

6. Target cathode apparatus according to claim 1 or any of claims 3 to 5, **characterized in that**, with a target (1) held by means of a strap (2), the envelope (8) covers substantially only the outer face of the strap (2).

7. Target cathode apparatus according to any claims 1 to 6, **characterized in that**, with a target (1) held by means of a strap (2), the strap (2) consist of different materials, the outside of the strap (2) consisting of soft-magnetic materials.

## Revendications

1. Ensemble cathode cible comprenant une cible (1) où se crée en fonctionnement un fossé d'érosion (6), avec sous la cible des éléments porteurs (3), un système de refroidissement et un système d'aimants qui maintient une plaque de fermeture arrière sur le côté de l'ensemble cathode cible situé à l'opposé de la cible,
**caractérisé en ce que**
l'ensemble cathode cible est équipé d'une enveloppe (8) faite d'un matériau faiblement magnétique qui recouvre la face externe de l'ensemble cathode cible en laissant libre la surface active de la cible au moins en partie, de manière que sur les points de cette surface où se trouve une composante normale d'un champ électrique, une composante tangentielle d'un champ magnétique de dispersion est au moins éliminée, l'enveloppe (8) étant en liaison électrique avec l'ensemble cathode cible.

2. Ensemble cathode cible selon la revendication 1,
**caractérisé en ce que**
l'enveloppe (8) entoure totalement la face externe dans la zone située entre la plaque de fermeture arrière (7) et le bord externe du fossé d'érosion (6).

3. Ensemble cathode cible selon la revendication 1 ou 2,
**caractérisé en ce que**
l'enveloppe (8) est faite d'une tôle d'une épaisseur comprise entre 0,3 et 3 mm.

4. Ensemble cathode cible selon une des revendications 1 à 3,
**caractérisé en ce que**
l'enveloppe (8) est fixée exclusivement par un verrouillage magnétique.

5. Ensemble cathode cible selon une des revendications 1 à 4,
**caractérisé en ce que**
l'enveloppe (8) est réalisée en plusieurs parties.

6. Ensemble cathode cible selon la revendication 1 ou une des revendications 3 à 5,
**caractérisé en ce que**
dans le cas d'une cible (1) maintenue par l'intermédiaire d'une barrette à griffes (2), l'enveloppe (8) recouvre essentiellement seulement la face externe de cette barrette (2).

7. Ensemble cathode cible selon une des revendications 1 à 6,
**caractérisé en ce que**
dans le cas d'une cible (1) maintenue par une barrette à griffes (2), celle-ci est composée de différents matériaux et a sa face externe faite d'un matériau faiblement magnétique.
